(19) Europäisches Patentamt
European Patent Office
Office européen des brevets

(11) **EP 1 094 468 B1**

(12) **EUROPÄISCHE PATENTSCHRIFT**

(45) Veröffentlichungstag und Bekanntmachung des Hinweises auf die Patenterteilung:
**16.07.2008 Patentblatt 2008/29**

(51) Int Cl.:
*G11C 11/22* *(2006.01)*

(21) Anmeldenummer: **00122642.2**

(22) Anmeldetag: **17.10.2000**

(54) **Anordnung zur Selbstreferenzierung von ferroelektrischen Speicherzellen**

A self-reference read scheme for ferroelectric memory cells

Mémoire ferro-électrique à référenciation automatique

(84) Benannte Vertragsstaaten:
**DE FR GB IE IT**

(30) Priorität: **20.10.1999 DE 19950581**

(43) Veröffentlichungstag der Anmeldung:
**25.04.2001 Patentblatt 2001/17**

(73) Patentinhaber: **Qimonda AG**
**81739 München (DE)**

(72) Erfinder:
• **Kowarik Oskar Dr.**
**85579 Neubiberg (DE)**
• **Hoffmann Kurt Prof.**
**82024 Taufkirchen (DE)**

(74) Vertreter: **Müller - Hoffmann & Partner Patentanwälte,**
**Innere Wiener Strasse 17**
**81667 München (DE)**

(56) Entgegenhaltungen:
EP-A- 0 486 901 DE-A- 19 860 799
US-A- 5 262 982 US-A- 5 995 407

• YAMADA J ET AL: "A self-reference read scheme for a 1T/1C FeRAM" 1998 SYMPOSIUM ON VLSI CIRCUITS. DIGEST OF TECHNICAL PAPERS (CAT. NO.98CH36215), 1998 SYMPOSIUM ON VLSI CIRCUITS DIGEST OF TECHNICAL PAPERS, HONOLULU, HI, USA, 11-13 JUNE 1998, Seiten 238-241, XP000980262 1998, New York, NY, USA, IEEE, USA ISBN: 0-7803-4766-8

**Beschreibung**

Die vorliegende Erfindung betrifft eine Anordnung zur Selbstreferenzierung einer ferroelektrischen Speicherzelle, die aus einem eine Zellplatte aufweisenden ferroelektrischen Speicherkondensator und einem Transfertransistor besteht und in einem über Wortleitungen und Bitleitungen angesteuerten Speicherzellenfeld vorgesehen ist, wobei der ferroelektrische Speicherkondensator zwischen einer Zellplattenleitung und dem Transfertransistor liegt und zur Selbstreferenzierung mittels eines Bewerters die Speicherzelle nach einem Lesevorgang zur Gewinnung einer Referenzspannung erneut eingeschrieben und ausgelesen wird.

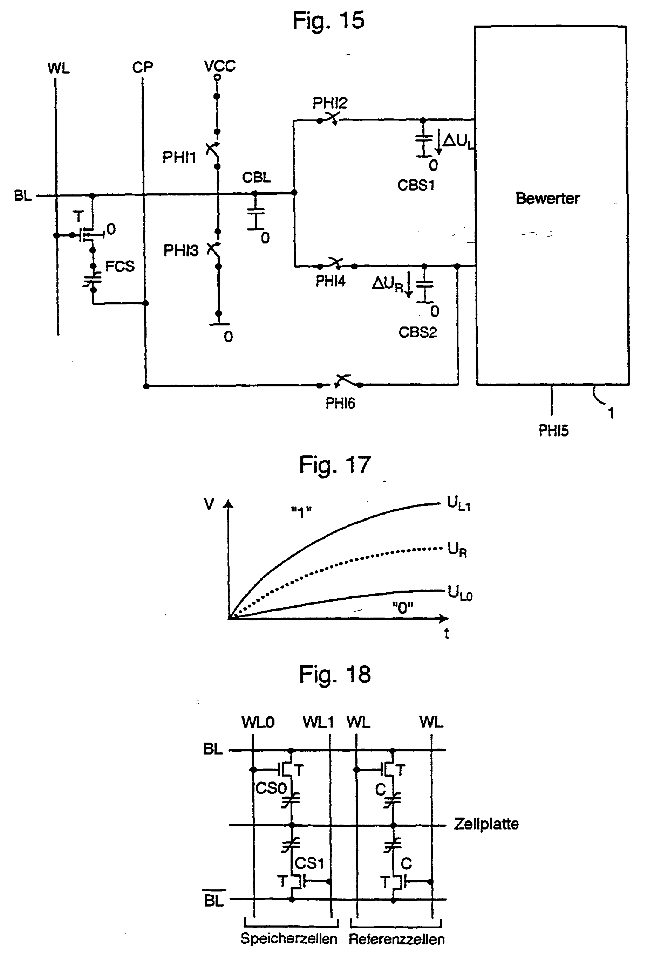

Bei herkömmlichen ferroelektrischen Speichern liegen, wie in Fig. 18 gezeigt ist, Speicherzellen aus ferroelektrischen Speicherkondensatoren Cs0, Cs1 und Transfertransistoren T zwischen Bitleitungen BL und Wortleitungen WL0, WL1. Die Zellplatten der Speicherzellen können parallel zu den Bitleitungen BL, wie in Fig. 18 gezeigt, oder auch parallel zu den Wortleitungen WL0, WL1 miteinander verbunden oder aber in beiden Richtungen zusammenhängend ausgeführt sein.

Beim Auslesen des Inhaltes einer solchen ferroelektrischen Speicherzelle entsteht auf der Bitleitung BL, abhängig davon, ob eine "1" oder eine "0" ausgelesen wird, eine Lesespannung $U_{L1}$ oder $U_{L0}$ (vgl. hierzu auch Fig. 17). Der Spannungsunterschied zwischen den Lesespannungen $U_{L1}$ und $U_{L0}$ liegt normalerweise in der Größenordnung von 100 mV.

Aufgabe einer mit dem Speicherzellenfeld verbundenen, sogenannten Bewerterschaltung - auch kurz "Bewerter" genannt - ist es dann, die Lesespannung $U_L$ auf der Bitleitung BL als "1" (also $U_{L1}$) oder "0" (also $U_{L0}$) zu detektieren und entsprechend zu verstärken. Die Detektion erfolgt dabei durch Vergleich der Lesespannung $U_L$ mit einer Referenzspannung $U_R$. Ist die Lesespannung größer als die Referenzspannung $U_R$, so wird eine "1" detektiert, ist sie kleiner, als die Referenzspannung $U_R$, so wird eine "0" detektiert.

Um dies zu erreichen, wird bisher in den meisten Fällen die Referenzspannung auf einer Referenzbitleitung $\overline{BL}$ durch das Auslesen des Inhalts einer Referenzzelle aus einem ferroelektrischen Speicherkondensator C und einem Transfertransistor T erzeugt, wobei diese Referenzzelle so dimensioniert und/oder geschaltet ist, daß sich die Referenzspannung $U_R$ in geeigneter Weise ergibt.

Die Referenzspannung $U_R$ sollte dabei auf einige mV genau sein und möglichst in der Mitte zwischen den Lesespannungen $U_{L1}$ für "1" und $U_{L0}$ für "0" liegen. Diese Forderung wirft aber erhebliche Probleme bei der Erzeugung der Referenzspannung $U_R$ während des Betriebs des ferroelektrischen Speichers auf:

(a) Die Lesespannung $U_L$ der ferroelektrischen Speicherzellen und die Referenzspannung $U_R$ der Referenzzellen streuen allein schon infolge des Herstellungsprozesses, der für alle Speicherzellen nicht in genau der gleichen Weise ablaufen kann.

(b) Abhängig von der Anzahl der Schreib- und Lesezyklen verändert sich infolge der Alterungseigenschaften "aging" (Hysteresekurve wird schmäler), "fatique" (Hysteresekurve dreht sich) und "imprint" (Hysteresekurve verschiebt sich nach oben oder unten) das elektrische Verhalten der ferroelektrischen Speicherzellen und der Referenzzellen, wobei dieser Alterungsprozeß für die beiden Zelltypen unterschiedlich abläuft.

Infolge der obigen Probleme (a) und (b) können sich die Lesespannung $U_L$ und/oder die Referenzspannung $U_R$ derart verschieben, daß ein korrektes Bewerten der Lesespannung $U_L$ als eine "1" oder eine "0" im Verlauf des Betriebes des ferroelektrischen Speichers nicht mehr möglich ist.

Um obige Schwierigkeiten zu umgehen, ist in J. Yamada u.a.: "A self-Refresh Read Scheme for a 1T/1C FeRAM", 1998 Symposium on VLSI Circuits Digest of Technical Papers, S. 238 und 239, eine Selbstreferenzierung einer Speicherzelle beschrieben, so daß das Problem einer unterschiedlichen Alterung von Speicherzelle und Referenzzelle umgangen wird. Bei dieser bekannten Selbstreferenzierung werden aber Schaltungsmaßnahmen, wie unterschiedliche Bitleitungskapazitäten oder Bewerter, zur Erzeugung der Referenzspannung eingesetzt, was eine erneute Abhängigkeit von der Alterung der Speicherzellen bedingt.

Eine Anordnung zur Selbstreferenzierung ferroelektrischer Speicherzellen wird bereits in US 5,262,982 A beschrieben. Für das Auslesen von ferroelektrischen Speicherzellen ohne Ladungsverlust wird eine Zellplattenleitung zu einem ferroelektrischen Speicherkondensator geführt und kann auf zwei voneinander verschiedene und entgegengesetzte Spannungen vorgeladen werden.

Es ist Aufgabe der vorliegenden Erfindung, eine Anordnung zur Selbstreferenzierung einer ferroelektrischen Speicherzelle anzugeben, bei der keine Abhängigkeit von der Alterung der Speicherzellen vorliegt und für die Gewinnung der Referenzspannung der Hysteresebereich soweit als möglich ausgenutzt wird.

Diese Aufgabe wird bei einer Anordnung der eingangs genannten Art erfindungsgemäß durch die Merkmale des Anspruchs 1 gelöst. Dabei ist die Speicherzelle nacheinander auslesbar , während die Bitleitung auf zwei voneinander verschiedenen Spannungen mit einem ersten bzw. einem zweiten Spannungswert vorgeladen ist, und der dabei gewonnene Spannungswert ist jeweils in einer ersten bzw. zweiten Kapazität zwischenspeicherbar, bevor er dem Bewerter zugeführt wird.

Die Zellplattenleitung ist mit einer Spannung eines zweiten bzw. ersten Spannungswertes beaufschlagt, wenn an der Bitleitung eine Spannung mit dem ersten bzw. zweiten Spannungswert anliegt. Die gepulste Zellplattenleitung hat den Vorteil, daß das Auftreten parasitärer Dioden in den Speicherzellen vermieden wird.

Bei gepulsten Zellplatten können diese linienweise parallel zu den Bitleitungen miteinander verbunden sein, wobei dann die Referenzspannung auf der Zellplattenleitung gewinnbar ist.

Alternativ ist es auch möglich, die Zellplatten linienweise parallel zu den Wortleitungen miteinander zu verbinden und die Referenzspannung auf der Bitleitung zu gewinnen.

Im Unterschied zu der Selbstreferenzierung nach "Yamada", bei der nur eine Hälfte der Hysteresekurve ausgenutzt wird, wertet die erfindungsgemäße Anordnung den gesamten Bereich der Hysteresekurve aus, wie dies weiter unten noch näher erläutert wird. Auch wird zur Erzeugung der Referenzspannung bei der erfindungsgemäßen Anordnung jegliche Abhängigkeit von der eingesetzten Technologie vermieden, und Abhängigkeiten von unterschiedlichen Alterungseigenschaften liegen nicht vor, da die jeweils ausgelesene Speicherzelle auch als Referenzzelle benutzt wird.

Nachfolgend wird die Erfindung anhand der Zeichnungen näher erläutert. Es zeigen:

Fig. 1 ein schematisches Diagramm zur Erläuterung des Auslesens einer "0" bei einer Anordnung mit fester Zellplattenspannung, welche hilfreich zum Verständnis der Erfindung ist,

Fig. 2 ein schematisches Diagramm zur Erläuterung des Auslesens einer "1" bei der Anordnung von Fig. 1,

Fig. 3 ein schematisches Diagramm zur Verdeutlichung von Unterschieden zwischen Ausleseverfahren

Fig. 4 eine schematische Schaltungsanordnung zur Erläuterung des Ausführungsbeispiels nach Fig. 2,

Fig. 5 den Verlauf von Signalen an einzelnen Teilen der Schaltungsanordnung von Fig. 4,

Fig. 6 ein konkretes Schaltungsbeispiel zur Realisierung der in Fig. 4 gezeigten Schaltungsanordnung,

Fig. 7 eine Schaltungsanordnung zur Erläuterung des prinzipiellen Aufbaues eines ferroelektrischen Speicherzellenfeldes mit in Bitleitungsrichtung verbundenen Zellplatten bei einem ersten Ausführungsbeispiel der Erfindung,

Fig. 8 eine Schaltungsanordnung zur Erläuterung des prinzipiellen Aufbaues eines ferroelektrischen Speicherzellenfeldes mit in Wortleitungsrichtung verbundenen Zellplatten bei einem weiteren Ausführungsbeispiel der vorliegenden Erfindung,

Fig. 9 eine schematische Darstellung zur Erläuterung des Auslesens einer "0" bei dem ersten Ausführungsbeispiel der Erfindung,

Fig. 10 eine schematische Darstellung zur Erläuterung des Auslesens einer "1" bei dem ersten Ausführungsbeispiel der Erfindung,

Fig. 11 ein schematisches Schaltbild der erfindungsgemäßen Anordnung nach dem ersten Ausführungsbeispiel der Erfindung,

Fig. 12 den Verlauf von Signalen an verschiedenen Stellen bei der Anordnung nach Fig. 11,

Fig. 13 ein Schaltbild einer Anordnung mit gemeinsamer Nutzung der Zellplattenleitung von zwei Bitleitungen zur Verringerung der Zellfläche bei dem ersten Ausführungsbeispiel der Erfindung,

Fig. 14 ein Schaltbild einer Anordnung mit gleich großen Kapazitäten der Bitleitungen und der Zellplattenleitung durch zweifache Verkreuzung bei dem ersten Ausführungsbeispiel der Erfindung,

Fig. 15 ein Schaltbild zur Erläuterung des prinzipiellen Aufbaues einer Ausleseschaltung bei einem weiteren Ausführungsbeispiel der vorliegenden Erfindung,

Fig. 16 den Verlauf von Signalen an verschiedenen Stellen der in Fig. 15 gezeigten Schaltung,

Fig. 17    ein schematisches Diagramm zur Erläuterung des Auslesens einer "1" oder einer "0" bei einem herkömmlichen ferroelektrischen Speicher (FeRAM) und

Fig. 18    ein Schaltbild zur Erläuterung des Aufbaues eines Speicherzellenfeldes bei einem herkömmlichen FeRAM.

Die Fig. 17 und 18 sind bereits eingangs erläutert worden. In den Figuren werden für einander entsprechende Bauteile die gleichen Bezugszeichen verwendet.

Das folgende Ausführungsbeispiel bezieht sich auf eine Anordnung hilfreich zum Verständnis der Erfindung zur Selbstreferenzierung mit fester Zellplattenspannung, während das erste und das zweite Ausführungsbeispiel der Erfindung Anordnungen mit gepulster Zellplattenspannung betreffen.

Bei der folgenden Anordnung wird zunächst, wie bei "Yamada", zur Erzeugung der Referenzspannung $U_R$ jeweils die gleiche Speicherzelle verwendet, die auch bereits zuvor zum Auslesen einer gespeicherten "1" oder "0" herangezogen wurde. Wie weiter unten noch näher erläutert werden wird und worauf bereits oben hingewiesen wurde, werden speziell über "Yamada" hinaus die folgenden wesentlichen Vorteile erreicht:

(a) Abhängigkeiten von unterschiedlichen Alterungserscheinungen für die ausgelesene Speicherzelle und die Referenzzelle liegen nicht vor, da es sich hier jeweils um dieselbe Zelle handelt.

(b) Die zur Bewertung zur Verfügung stehende Differenzspannung $U_L$ - $U_R$ ist erheblich größer und kann bei gleicher Zellgröße bis zum ca. 2-fachen Wert bisheriger Differenzspannungen reichen.

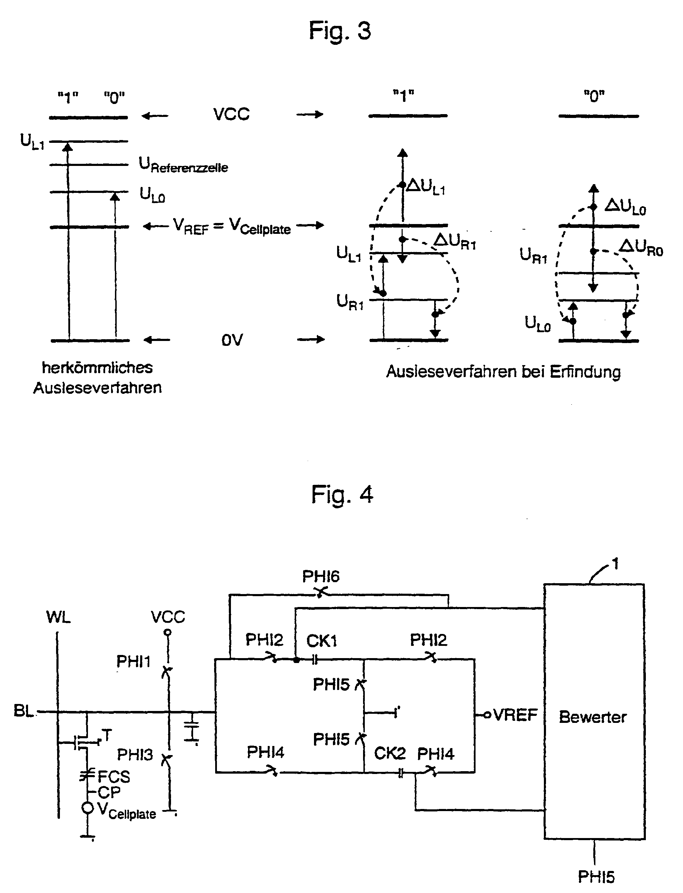

Bei der folgenden Anordnung wird in einem ersten Schritt I eine Bitleitung BL (vgl. beispielsweise Fig. 4) auf beispielsweise Versorgungsspannung VCC aufgeladen; sodann wird der Inhalt einer adressierten Speicherzelle durch Aktivierung einer Wortleitung WL auf diese Bitleitung BL ausgelesen. Hierbei soll eine Zellplatte CP eines ferroelektrischen Speicherkondensators FCS fest auf einer Referenzspannung $V_{ref}$ = $V_{cellplate}$ = VCC/2 liegen. Dies bedeutet, daß die Zellplatte CP bei einer Versorgungsspannung VCC = 3 V auf 1,5 V festgelegt ist.

Die sich dabei auf der Bitleitung BL ergebende Spannung $\Delta U_L$ wird in einer Kapazität CK1 zwischengespeichert. Die zugehörige Wortleitung WL sperrt hierauf den Transfertransistor T der ausgelesenen Speicherzelle.

In einem zweiten Schritt II wird sodann die Bitleitung BL auf 0 V vorgeladen, und der Transfertransistor T der Speicherzelle wird durch Anlegen eines Wortleitungsimpulses an die Wortleitung WL wieder geöffnet. Es stellt sich dann auf der Bitleitung BL eine Referenzspannung $\Delta U_R$ ein. Diese Referenzspannung wird in einer Kapazität CK2 zwischengespeichert.

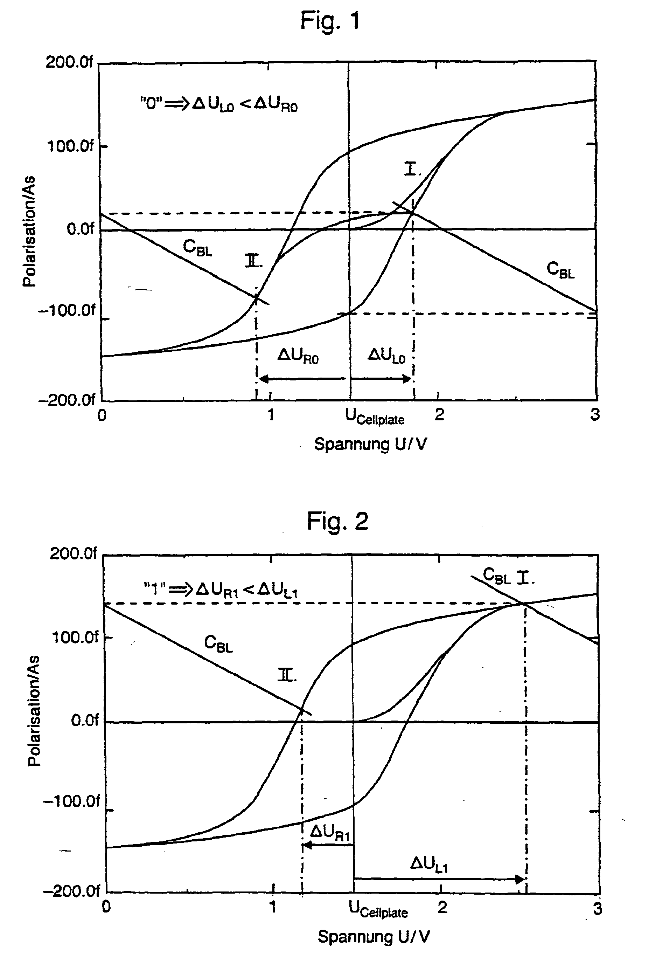

Die Spannungen $\Delta U_L$ und $\Delta U_R$ sind auf $V_{ref}$ = VCC/2 bezogen, wie dies in den Fig. 1 und 2 als graphische Lösung des Auslesens in Schritt I und Schritt II für eine "0" und eine "1" gezeigt ist. Die Lösung ergibt sich dabei als Schnittpunkt der Hysteresekurve der ferroelektrischen Speicherzelle und der einmal ausgehend von +3 V und einmal ausgehend von 0 V als gerade aufgetragenen Bitleitungskapazität $C_{BL}$.

Wesentlich ist nun, daß sich bezogen auf die Referenzspannung $V_{ref}$ = VCC/2 für eine gespeicherte "0" zuerst eine Lese-Spannungsdifferenz $\Delta U_{L0}$ ergibt, welche deutlich kleiner ist als die beim zweiten Auslesen erhaltene Referenz-Spannungsdifferenz $\Delta U_{R0}$ (vgl. Fig. 1). Umgekehrt ergibt sich für eine gespeicherte "1" eine Lese-Spannungsdifferenz $\Delta U_{L1}$, die deutlich größer ist als die beim zweiten Auslesen erhaltene Referenz-Spannungsdifferenz $\Delta U_{R1}$ (vgl. Fig. 2).

Wie aus den Diagrammen der Fig. 1 und 2 zu ersehen ist, wird bei dieser Anordnung der gesamte Bereich der Hysteresekurve, nämlich der Bereich links und rechts von der "Nullinie" für die Gewinnung der Lesespannung und der Referenzspannung herangezogen.

Damit die oben angegebenen Beziehungen

$$\text{"0"} \implies \Delta U_{R0} > \Delta U_{L0} \tag{1}$$

$$\text{"1"} \implies \Delta U_{R1} < \Delta U_{L1} \tag{2}$$

erhalten werden, muß die Größe der Bitleitungskapazität $C_{BL}$ durch geeignetes Design der Bitleitung BL entsprechend gewählt werden. Der zulässige Wertebereich für die Bitleitungskapazität $C_{BL}$ wird hierbei durch die Hysteresekurve der ferroelektrischen Zellkapazität vorgegeben (vgl. die Fig. 1 und 2).

Die jeweilige Lese-Spannungsdifferenz $\Delta U_{L1}$ für "1" bzw. $\Delta U_{L0}$ für "0" und die zugehörige Referenz-Spannungsdifferenz $\Delta U_{R1}$ für "1" bzw. $\Delta U_{R0}$ für "0", die sich auf die Zellplattenspannung $V_{cellplate}$ = $V_{ref}$ = VCC/2 beziehen, werden nun so verschoben, daß sich sowohl $\Delta U_L$ als auch $\Delta U_R$ auf eine gemeinsame Spannung, beispielsweise 0 V, ausgerichtet sind, wie dies in Fig. 3 (rechte Hälfte; Strichpfeile) veranschaulicht ist, um dann direkt an die beiden Eingänge eines Bewerters 1 (vgl. Fig. 4) angelegt, verstärkt, detektiert und in die Speicherzelle zurückgeschrieben zu werden.

Wie aus der Fig. 3 zu ersehen ist, ist die für die Bewertung zur Verfügung stehende Differenzspannung $U_L - U_R$ bei dieser Anordnung (rechte Hälfte von Fig. 3) größer als bei der herkömmlichen Anordnung.

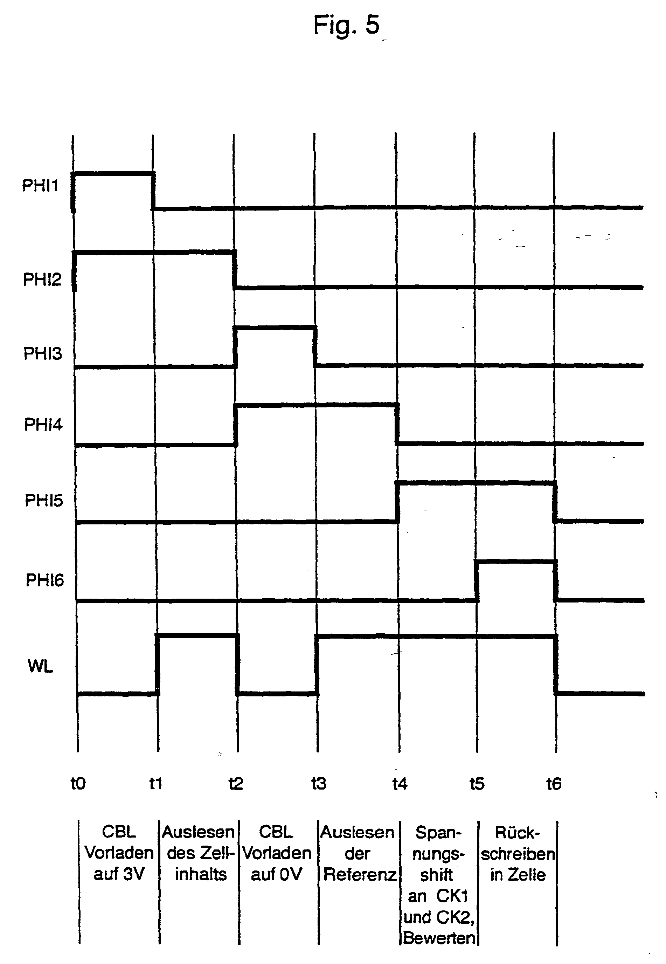

Die Fig. 4 zeigt, wie bereits erwähnt wurde, ein erstes Ausführungsbeispiel dieser Anordnung. Die Arbeitsweise dieser Anordnung soll im folgenden anhand der Fig. 5 näher erläutert werden.

Zunächst wird während einer Zeit t0-t1 die Bitleitung BL auf 0 V mittels eines Schalters PHI1 auf VCC, beispielsweise 3 V, vorgeladen. Die Kapazität CK1 wird mittels des Schalters PHI1 und eines Schalters PHI2 auf 3 V bzw. VREF vorgeladen. Im Zeitpunkt t1 wird der Schalter PHI1 deaktiviert.

Während der Zeitdauer t1-t2 wird der Inhalt der Speicherzelle aus dem ferroelektrischen Speicherkondensator FCS und dem Transfertransistor T auf die Bitleitung BL und zur Kapazität CK1 mittels der Wortleitung WL und des Schalters PHI2 ausgelesen. Im Zeitpunkt t2 werden die Wortleitung WL und der Schalter PHI2 deaktiviert.

Während der Zeitdauer t2-t3 wird die Bitleitung BL mittels des Schalters PHI3 auf 0 V vorgeladen, und die Kapazität CK2 wird mittels des Schalters PHI3 und eines Schalters PHI4 auf 0 V bzw. VREF gebracht. Im Zeitpunkt t3 wird der Schalter PHI3 deaktiviert.

Während der Zeitdauer t3-t4 wird der jetzige Inhalt der Speicherzelle aus dem ferroelektrischen Speicherkondensator FCS und dem Transfertransistor T auf die Bitleitung BL und zur Kapazität CK2 mittels der Wortleitung WL und des Schalters PHI4 ausgelesen. Im Zeitpunkt t4 wird der Schalter PHI4 deaktiviert.

Während der Zeitdauer t4-t5 wird ein Schalter PHI5 aktiviert. Dadurch erfolgt ein Umladen der Fußpunkte der Kapazitäten CK1 und CK2 (vgl. Fig. 3) und eine Aktivierung des Bewerters 1.

Schließlich erfolgt während einer Zeitdauer t5-t6 ein Rückschreiben vom Bewerter 1 in den Speicherkondensator FCS durch Aktivieren eines Schalters PHI6.

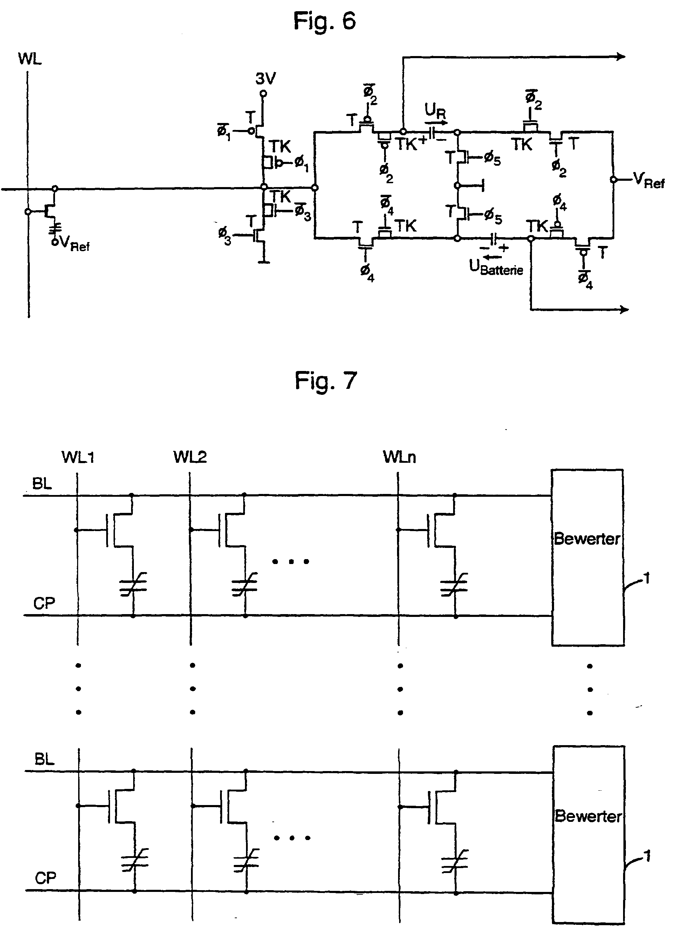

Die einzelnen Schalter PHI1 bis PHI6 können beispielsweise in CMOS-Technologie ausgeführt werden, wie dies schematisch in Fig. 6 mit einzelnen Ansteuersignalen $\phi_1$, $\phi_2$, $\phi_3$, $\phi_4$, $\overline{\phi_1}, \overline{\phi_2}, \overline{\phi_3}$ und $\overline{\phi_4}$ gezeigt ist. Für die Schalter werden dabei Transfertransistoren T und kurzgeschlossene Transistoren TK verwendet werden. Solche Transfertransistoren T und kurzgeschlossene Transistoren TK sind beispielsweise aus Analog/Digital-Wandlern bekannt. Die kurzgeschlossenen Transistoren TK sind dabei etwa halb so groß zu dimensionieren wie die Transfertransistoren T und mit den inversen Steuersignalen $\overline{\phi_i}$ anzusteuern, wenn an den Transfertransistoren T die Steuersignale $\phi_i$ anliegen.

Es ist ohne weiteres möglich, das Auslesen der Lesespannung (Schritt I; vgl. oben) auf eine auf 0 V vorgeladene Bitleitung BL vorzunehmen und anschließend die Referenzspannung durch die auf die Versorgungsspannung VCC vorgeladene Bitleitung zu erzeugen. Auch können die Lesespannung und die Referenzspannung nicht nur auf 0 V, sondern auch auf einen anderen Spannungsbezugspunkt, beispielsweise die Versorgungsspannung VCC, transformiert werden, wenn dies für den Bewerter 1 von Vorteil ist.

Anhand der Fig. 7 bis 14 wird nunmehr das erste Ausführungsbeispiel der Erfindung näher erläutert. Bei diesem Ausführungsbeispiel sind die Zellplatten linienweise parallel zu den Bitleitungen miteinander verbunden, und die Zellplattenleitungen werden zum Auslesen und Zurückschreiben des Speicherzelleninhaltes gepulst.

Zunächst zeigt Fig. 7 den prinzipiellen Aufbau eines ferroelektrischen Speicherzellenfeldes mit in Richtung der Bitleitungen BL miteinander verbundenen Zellplatten CP. Das heißt, bei diesem Ausführungsbeispiel sind die Zellplatten CP aller Zellen an der Bitleitung Bh mit dem Bewerter 1 verbunden.

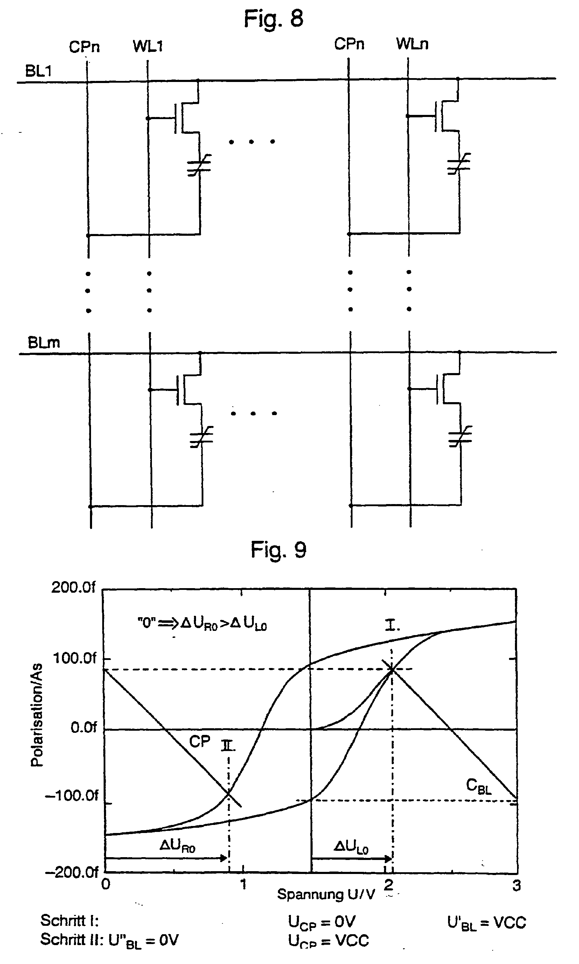

Im Gegensatz hierzu zeigt Fig. 8 eine Schaltungsanordnung eines ferroelektrischen Speicherzellenfeldes mit in Richtung von Wortleitungen WL1, ..., WLn verbundenen Zellplatten CPn. Ein derartiges Speicherzellenfeld wird bei dem weiter unten näher erläuterten dritten Ausführungsbeispiel verwendet.

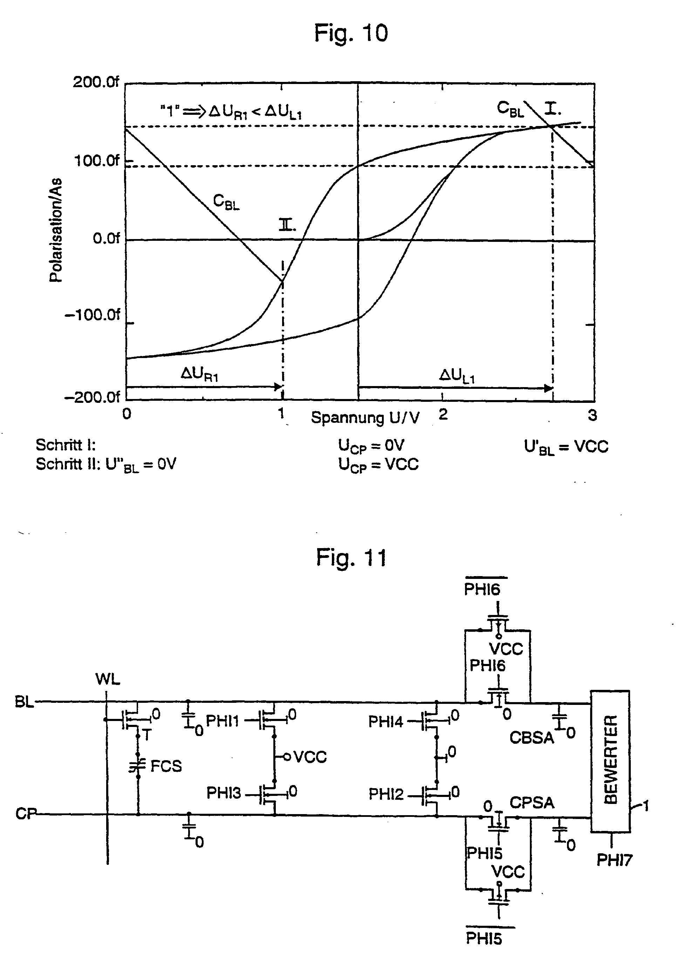

Bei dem ersten Ausführungsbeispiel (vgl. Fig. 11) wird in einem Schritt I eine Bitleitung BL auf beispielsweise Versorgungsspannung VCC aufgeladen. Dann wird der Inhalt einer adressierten Speicherzelle aus einem ferroelektrischen Speicherkondensator FCS und einem Transfertransistor T auf diese Bitleitung BL ausgelesen. Hierbei wird die Zellplattenleitung CP auf die zur Bitleitungsvorspannung entgegengesetzte Spannung, also beispielsweise auf 0 V gelegt. Die sich dabei aus der Bitleitung BL ergebende Spannung $\Delta U_L$ wird in einer Kapazität CBSA zwischengespeichert. Die zugehörige Wortleitung WL sperrt hierauf den Transfertransistor T der ausgelesenen Speicherzelle.

In einem Schritt II wird sodann die Bitleitung BL auf 0 V gelegt. Die Zellplattenleitung CP an der Speicherzelle wird sodann auf die zur Bitleitungsspannung entgegengesetzte Spannung, also beispielsweise VCC vorgeladen, und der Transfertransistor T der Speicherzelle wird durch Anlegen des Wortleitungsimpulses wieder geöffnet. Es stellt sich dann auf der Zellplattenleitung CP eine Referenzspannung $\Delta U_R$ ein. Diese Referenzspannung $\Delta U_R$ wird in einer Kapazität CPSA zwischengespeichert.

Der obige Vorgang ist in den Figuren 9 und 10 als graphische Lösung des Auslesens in einem Schritt I und einem Schritt II für eine "0" und eine "1" dargestellt. Die Lösung ergibt sich dabei als Schnittpunkt der Hysteresekurve des ferroelektrischen Speicherkondensators FCS und der einmal von einer Bitleitungsspannung $U'_{BL} = VCC$ und einmal von einer Bitleitungsspannung $U''_{BL} = 0$ V als gerade aufgetragenen Bitleitungskapazität CBL bzw. Kapazität der Zellplattenleitung CP. Eine Spannung $U_{CP}$ entspricht in dem Schritt I 0 V, während sie in dem Schritt II die Größe der Versorgungsspannung VCC hat.

Wesentlich an diesem Ausführungsbeispiel ist nun, daß sich wie im ersten Ausführungsbeispiel für eine "0" zuerst eine Lese-Spannungsdifferenz $\Delta U_{L0}$ ergibt, die kleiner ist als die sich beim zweiten Auslesen ergebende Referenz-Spannungsdifferenz $\Delta U_{R0}$ (vgl. Fig. 9). Umgekehrt ergibt sich für eine "1" eine Lese-Spannungsdifferenz $\Delta U_{L1}$, die größer ist als die sich beim zweiten Auslesen ergebende Referenz-Spannungsdifferenz $\Delta U_{R1}$ (vgl. Fig. 10).

Mit anderen Worten, es gelten auch hier die oben für das erste Ausführungsbeispiel angegebenen Beziehungen (1) und (2).

Die Größe der Kapazität der Bitleitung BL sowie die Größe der Kapazität der Zellplattenleitung CP können durch entsprechendes Design ohne weiteres so festgelegt werden, daß die obigen Beziehungen (1) und (2) eingehalten werden. Der zulässige Wertebereich für die Bitleitungskapazität CBL bzw. für die Kapazität der Zellplattenleitung CP wird hierbei durch die Hysteresekurve sowie die Kapazität des ferroelektrischen Speicherkondensators FCS vorgegeben (vgl. Fig. 9 und 10).

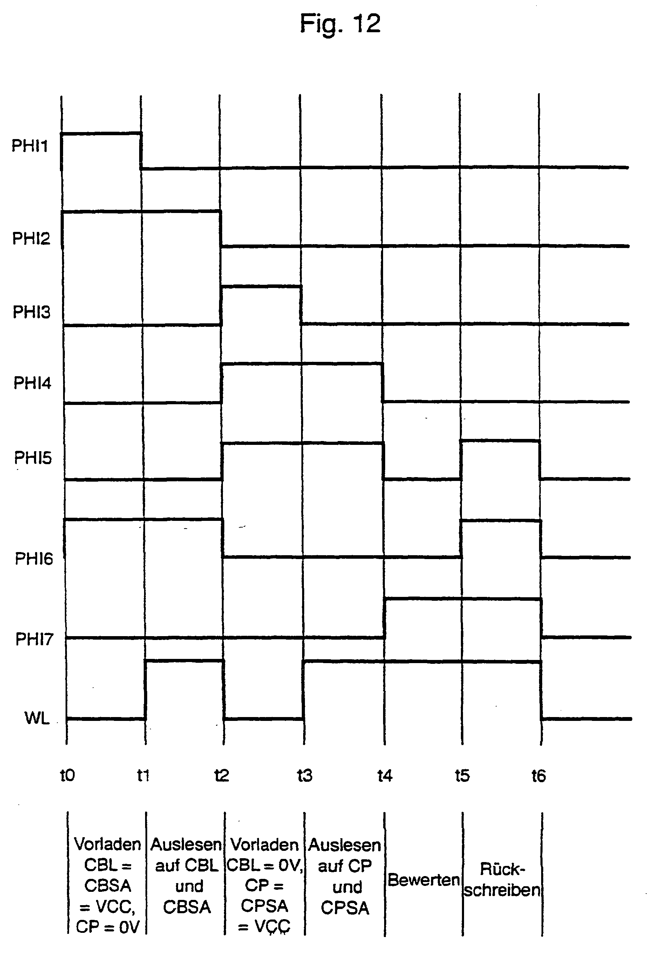

Anhand der Fig. 11 und 12 soll im folgenden der Betrieb der erfindungsgemäßen Anordnung nach dem ersten Ausführungsbeispiel näher erläutert werden.

Während einer Zeit t0-t1 wird die Bitleitung BL vorgeladen und die Kapazität CBSA auf Versorgungsspannung VCC, beispielsweise 3 V mittels des Schalters PHI1 sowie von Schaltern PHI6 und $\overline{PHI6}$ gebracht. Die Zellplattenleitung CP wird mit Hilfe des Schalters PHI2 auf 0 V gesetzt. In einem Zeitpunkt t1 wird der Schalter PHI1 deaktiviert.

Während einer Zeit t1-t2 wird der Inhalt des Speicherkondensators FCS auf die Bitleitung BL durch entsprechende Ansteuerung der Wortleitung WL ausgelesen und in der Kapazität CBSA gespeichert. Die Schalter PHI2 und PHI6 bzw. $\overline{PHI6}$ werden im Zeitpunkt t2 deaktiviert.

In einem Zeitraum t2-t3 werden die Zellplattenleitung CP und die Kapazität CPSA auf die Versorgungsspannung VCC, also beispielsweise 3 V, mittels der Schalter PHI3 und PHI5 sowie $\overline{PHI5}$ vorgeladen, und die Bitleitung BL wird mittels des Schalters PHI4 auf 0 V gebracht. In einem Zeitpunkt t3 wird der Schalter PHI3 deaktiviert.

Während eines Zeitraumes t3-t4 wird der jetzige Inhalt des Speicherkondensators FCS auf die Zellplattenleitung CP ausgelesen und in der Kapazität CPSA gespeichert, indem die Wortleitung WL entsprechend angesteuert wird. In einem Zeitpunkt t4 werden die Schalter PHI4 und PHI5 bzw. $\overline{PHI5}$ deaktiviert.

In einem Zeitraum t4-t5 wird ein Schalter PHI7 zur Aktivierung des Bewerters 1 aktiviert.

Schließlich erfolgen in einem Zeitraum t5-t6 ein Rückschreiben vom Bewerter 1 in den ferroelektrischen Speicherkondensator FCS durch Aktivieren der Schalter PHI5 bzw. $\overline{PHI5}$ sowie der Schalter PHI6 bzw. $\overline{PHI6}$. Schließlich werden alle Schalter deaktiviert.

Die Schalter PHI5 bzw. $\overline{PHI5}$ und die Schalter PHI6 bzw. $\overline{PHI6}$ sind gewählt, um immer die volle Spannung VCC bzw. 0 V vom Bewerter 1 in die ferroelektrische Speicherzelle rückschreiben zu können. Diese Schalter werden zur Verringerung des Platzbedarfs vorzugsweise durch n-Kanal-MOS-Transistoren realisiert. Allerdings sollten dann die Pulse an den Schalter PHI5 und PHI6 wie der Impuls auf der Wortleitung WL spannungsmäßig überhöht sein.

Die Schalter selbst können in ähnlicher Weise wie im ersten Ausführungsbeispiel in CMOS-Technologie ausgeführt werden.

Auch ist es ohne weiteres möglich, das Auslesen der Lesespannung (Schritt I) genaue umgekehrt zu dem obigen Beispiel zuerst auf eine auf 0 V vorgeladene Bitleitung BL vorzunehmen und anschließend die Referenzspannung durch eine auf VCC vorgeladene Zellplattenleitung CP zu erzeugen.

Auch können die Vorladespannungen, also im obigen Beispiel 0 V und die Versorgungsspannung VCC, im vorgegebenen Rahmen der Beziehungen "1" und "2" verändert werden, falls dies für den Bewerter 1 von Vorteil ist.

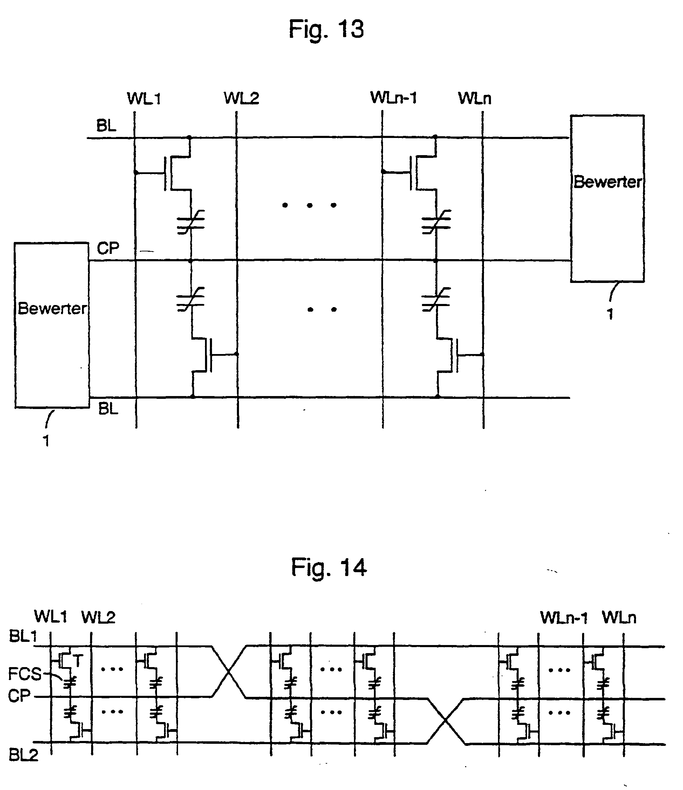

Die Zellplattenleitung CP kann ohne weiteres gemeinsam jeweils durch zwei Bitleitungen genutzt werden, wodurch die erforderliche Chipfläche erheblich reduziert werden kann. Ein Beispiel hierfür ist in Fig. 13 gezeigt.

Die Kapazität der Bitleitung BL und die Kapazität der Zellplattenleitung PC müssen nicht, wie in den Fig. 9 und 10 dargestellt ist, exakt gleich groß sein; sie können durchaus im Rahmen des durch die Hysteresekurve des ferroelektrischen Speicherkondensators vorgegebenen Wertebereiches unterschiedlich groß sein. Sollten hierdurch bei der Detektion Probleme auftreten, so kann gegebenenfalls eine zweifache Verkreuzung vorgenommen werden, wie dies in Fig. 14 dargestellt ist.

Die Bitleitung BL und die Zellplattenleitung CP sind in dem Beispiel von Fig. 13 mit den Auswahltransistoren T bzw. den Zellplatten der Speicherkondensatoren verbunden und bestehen in der Regel auch aus unterschiedlichem Material, wie beispielsweise polykristallinem Silizium oder Aluminium, so daß sie unterschiedliche Kapazitäten aufweisen. Dies ist für die Detektion des Lesesignales ungünstig.

Auch hier kann eine Anordnung gemäß Fig. 14 Abhilfe schaffen: hier sind die Zellplattenleitung CP sowie die zugehörigen beiden Bitleitungen BL1, BL2 so miteinander verkreuzt, daß die Kapazitäten für die Bitleitungen BL1, BL2 und die Zellplattenleitung CP gleich groß sind.

Im folgenden soll noch anhand der Fig. 8 bis 10, 15 und 16 ein weiteres Ausführungsbeispiel der vorliegenden Erfindung näher erläutert werden. Bei diesem zweiten Ausführungsbeispiel sind die Zellplatten parallel zu den Wortleitungen WL miteinander verbunden, und die Zellplattenleitungen CP sind zum Auslesen und Zurückschreiben des Speicherzelleninhaltes gepulst.

Auch bei diesem Ausführungsbeispiel wird in einem Schritt I eine Bitleitung BL (vgl. Fig. 15) auf beispielsweise Versorgungsspannung VCC aufgeladen. Dann wird der Inhalt einer adressierten Speicherzelle mit dem Speicherkondensator FCS durch Aktivierung der Wortleitung WL auf diese Bitleitung BL ausgelesen. Hierbei sollte die Zellplattenleitung CP auf die zur Bitleitungsvorspannung entgegengesetzte Spannung, also beispielsweise auf 0 V gelegt sein. Die sich dadurch auf der Bitleitung BL ergebende Spannung $\Delta U_L$ wird in einer Kapazität CBS1 zwischengespeichert.

Die zugehörige Wortleitung WL sperrt hierauf den Auslese- bzw. Transfertransistor T der ausgelesenen Speicherzelle.

In einem Schritt II wird sodann die Bitleitung BL auf 0 V gelegt. Die Zellplattenleitung CP an der Speicherzelle wird auf die zur Bitleitungsvorspannung entgegengesetzte Spannung, also beispielsweise auf VCC vorgeladen, und der Transfertransisistor T dieser Speicherzelle wird durch Anlegen eines Wortleitungsimpulses an die Wortleitung WL wieder geöffnet.

Es stellt sich nun auf der Bitleitung BL eine Referenzspannung $\Delta U_R$ ein, die in einer Kapazität CBS2 zwischengespeichert wird.

Der obige Vorgang ist wieder in den Fig. 9 und 10 gezeigt, die eine graphische Lösung des Auslesens in Schritt I und Schritt II für eine "0" und eine "1" darstellen. Die Lösung ergibt sich dabei wie im zweiten Ausführungsbeispiel als Schnittpunkt der Hysteresekurve des ferroelektrischen Speicherkondensators und der einmal von $U'_{BL} = VCC$ und einmal von $U''_{BL} = 0$ V als Gerade aufgetragenen Bitleitungskapazität CBL der Bitleitung BL. Die Spannung $U_{CP}$ entspricht dabei wieder in Schritt I dem Wert 0 V und in Schritt II der Versorgungsspannung VCC, also beispielsweise 3 V.

Auch in diesem Ausführungsbeispiel gelten die Beziehungen (1) und (2).

Die Bitleitungskapazität CBL der Bitleitung BL sollte auch hier durch entsprechendes Design gewählt werden, damit die Beziehungen (1) und (2) eingehalten sind. Der zulässige Wertebereich für die Bitleitungskapazität CBL ist hierbei - wie in den vorangehenden Ausführungsbeispielen - durch die Hysteresekurve des ferroelektrischen Speicherkondensators FCS vorgegeben (vgl. Fig. 9 und 10).

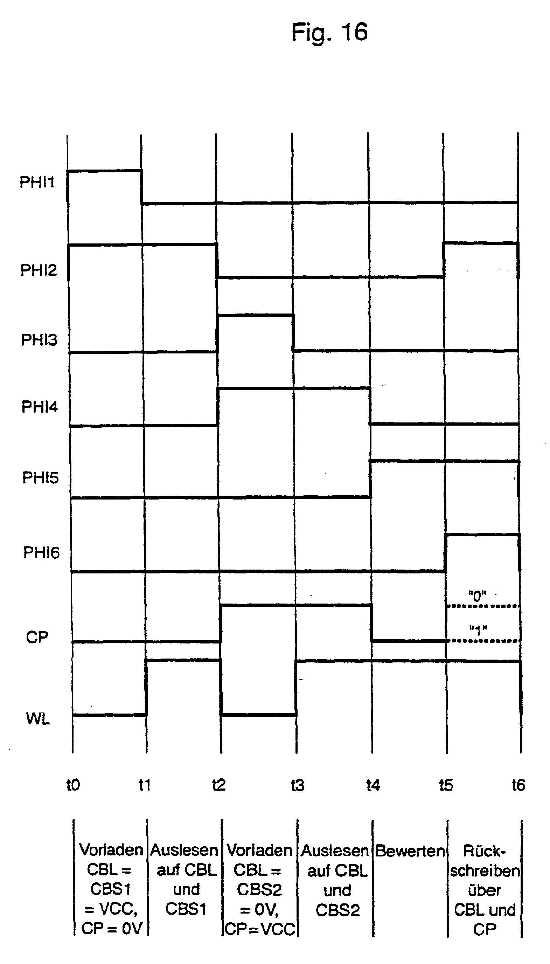

Anhand der Fig. 15 und 16 soll im folgenden die Betriebsweise der erfindungsgemäßen Anordnung gemäß dem diesem Ausführungsbeispiel näher erläutert werden.

Zunächst werden während einer Zeitdauer t0-t1 die Bitleitung BL sowie eine Kapazität CBS1 auf Versorgungsspannung VCC, also beispielsweise 3 V, mit Hilfe der Schalter PHI1 und PHI2 aufgeladen, wobei die Zellplattenleitung CB auf 0 V liegt. Im Zeitpunkt t1 wird der Schalter PHI1 deaktiviert.

Sodann wird in einem Zeitraum t1-t2 der Inhalt des Speicherkondensators FCS auf die Bitleitung BL und die Kapazität CBS1 durch entsprechende Ansteuerung der Wortleitung WL ausgelesen. Im Zeitpunkt t2 wird der Schalter PHI2 geöffnet und die Wortleitung WL abgeschaltet.

Während eines folgenden Zeitraumes t2-t3 wird die Zellplattenleitung CP mit VCC, also 3 V, aktiviert. Die Bitleitung BL und ein Kondensator CBS2 werden auf 0 V mit Hilfe der Schalter PHI3 bzw. PHI4 aufgeladen. Im Zeitpunkt t3 wird der Schalter PHI3 deaktiviert.

Während eines folgenden Zeitraumes t3-t4 wird der jetzige Inhalt des ferroelektrischen Speicherkondensators FCS auf die Bitleitung BL und die Kapazität CBS2 mit Hilfe entsprechender Ansteuerung der Wortleitung WL ausgelesen. Im Zeitpunkt t4 wird der Schalter PHI4 deaktiviert.

Während eines Zeitraumes t4-t5 wird der Bewerter 1 mittels des Schalters PHI5 aktiviert.

Schließlich erfolgt während eines Zeitraumes t5-t6 ein Rückschreiben vom Bewerter 1 in den ferroelektrischen Speicherkondensator FCS durch Aktivieren der Schalter PHI2 und PHI6 sowie der Wortleitung WL. Schließlich werden im Zeitpunkt t6 alle Schalter deaktiviert.

Wie in dem vorangehenden Ausführungsbeispiel bestehen die Schalter vorzugsweise aus einer Kombination von n- und p-Kanal-MOS-Transistoren. Sie sind dabei so gewählt, daß immer die volle Spannung, also beispielsweise die Versorgungsspannung VCC und 0 V in die Kapazitäten CBS1 bzw. CBS2 oder vom Bewerter 1 in den Speicherkondensator FCS geschrieben werden kann. Zur Verringerung des Platzbedarfes können auch lediglich n-Kanal-MOS-Transistoren eingesetzt werden. Allerdings sollten dann die Spannungsimpulse an den Schaltern sowie der Wortleitungsimpuls auf der Wortleitung WL spannungsmäßig überhöht sein.

Auch bei diesem Ausführungsbeispiel kann das Auslesen der Lesespannung (Schritt I) genau umgekehrt zu dem oben erläuterten Beispiel vorgenommen werden, wie dies anhand des vorherigen Ausführungsbeispieles beschrieben wurde. Gleiches gilt auch für Veränderungen der Vorladespannungen im Rahmen der obigen Beziehungen (1) und (2). Schließlich kann auch beim zweiten Ausführungsbeispiel die Zellplattenleitung gemeinsam durch jeweils zwei Wortleitungen genutzt werden, wodurch eine erhebliche Reduzierung der Chipfläche ermöglicht wird.

**Patentansprüche**

1. Anordnung zur Selbstreferenzierung einer ferroelektrischen Speicherzelle (FCS, T), die aus einem eine Zellplatte aufweisenden ferroelektrischen Speicherkondensator (FCS) und einem Transfertransistor (T) besteht und in einem über Wortleitungen (WL) und Bitleitungen (BL) angesteuerten Speicherzellenfeld vorgesehen ist, wobei der ferroelektrische Speicherkondensator (FCS) zwischen einer Zellplattenleitung (CP) und dem Transfertransistor (T) liegt und zur Selbstreferenzierung mittels eines Bewerters (1) die Speicherzelle nach einem Lesevorgang zur Gewinnung einer Referenzspannung erneut ausgelesen wird, wobei die Speicherzelle (FCS, T) nacheinander auslesbar ist, während die Zellplattenleitung (CP) mit einem zweiten bzw. einem ersten Spannungswert beaufschlagt ist, und daß die beiden dabei gewonnenen Spannungswerte jeweils in einer ersten bzw. zweiten Kapazität (CK1, CK2; CBSA, CPSA; CBS1, CBS2) zwischenspeicherbar sind, bevor sie dem Bewerter (1) zugeführt sind, um dort miteinander verglichen zu werden,
**dadurch gekennzeichnet, dass**
die Bitleitung (BL) für die beiden Auslesevorgänge nacheinander auf zwei voneinander verschiedenen und entgegengesetzten (VCC, 0 V) Spannungen mit einem ersten bzw. zweiten Spannungswert vorgeladen ist und zwar für den ersten Auslesevorgang mit der ersten Spannung und für den zweiten Auslesevorgang mit der zweiten Spannung.

2. Anordnung nach Anspruch 1,
**dadurch gekennzeichnet, dass**
die Zellplatten linienweise parallel zu den Bitleitungen (BL) miteinander verbunden sind und dass die Referenzspannung auf der Zellplattenleitung (CP) gewinnbar ist (Fig. 11).

3. Anordnung nach Anspruch 1,
**dadurch gekennzeichnet, dass**
die Zellplatten linienweise parallel zu den Wortleitungen (WL) miteinander verbunden sind, und dass die Referenzspannung auf der Bitleitung (BL) gewinnbar ist (Fig. 15).

4. Anordnung nach einem der Ansprüche 1 bis 3,
**dadurch gekennzeichnet, dass**
nach dem ersten Vorladen der Bitleitung (BL) der Transfertransistor (T) gesperrt ist.

5. Anordnung nach einem der Ansprüche 1 bis 4,
**dadurch gekennzeichnet, dass**
eine Zellplattenleitung (CP) von zwei Bitleitungen (BL) gemeinsam genutzt wird.

6. Anordnung nach einem der Ansprüche 1 bis 5,
**dadurch gekennzeichnet, dass**
die Bitleitungen (BL) und die Zellplattenleitung (CP) wenigstens einmal miteinander verkreuzt sind.

7. Anordnung nach einem der Ansprüche 1 bis 6,
**dadurch gekennzeichnet, daß**
die beiden voneinander verschiedenen Spannungen durch 0 V und eine Versorgungsspannung (VCC) gegeben sind.

**Claims**

1. Arrangement for self-referencing a ferroelectric memory cell (FCS, T) which comprises a ferroelectric storage capacitor (FCS) having a cell plate and a transfer transistor (T) and is provided in a memory cell array driven via word lines (WL) and bit lines (BL), wherein the ferroelectric storage capacitor (FCS) is connected between a cell plate line (CP) and the transfer transistor (T) and for self-referencing, by means of an evaluation unit (1), the memory cell is read again after a read operation in order to obtain a reference voltage, wherein the memory cell (FCS, T) can be read successively while a second and a first voltage value are respectively applied to the cell plate line (CP), and wherein the two voltage values obtained in this case can respectively be buffer-stored in a first and second capacitance (CK1, CK2; CBSA, CPSA; CBS1, CBS2) before they are fed to the evaluation unit (1) in order to be compared with one another there,
**characterized in that**
the bit line (BL) is precharged for the two read-out operations successively to two mutually different and opposite (VCC, 0 V) voltages having a first and second voltage value, respectively, to be precise with the first voltage for the first read-out operation and with the second voltage for the second read-out operation.

2. Arrangement according to Claim 1,
   **characterized in that**
   the cell plates are connected to one another in lines parallel to the bit lines (BL), and **in that** the reference voltage can be obtained on the cell plate line (CP) (figure 11).

3. Arrangement according to Claim 1,
   **characterized in that**
   the cell plates are connected to one another in lines parallel to the word lines (WL), and **in that** the reference voltage can be obtained on the bit line (BL) (figure 15).

4. Arrangement according to any of Claims 1 to 3,
   **characterized in that**
   the transfer transistor (T) is turned off after the first precharging of the bit line (BL).

5. Arrangement according to any of Claims 1 to 4,
   **characterized in that**
   a cell plate line (CP) is used jointly by two bit lines (BL).

6. Arrangement according to any of Claims 1 to 5,
   **characterized in that**
   the bit lines (BL) and the cell plate line (CP) are crossed with one another at least once.

7. Arrangement according to any of Claims 1 to 6,
   **characterized in that**
   the two mutually different voltages are given by 0 V and a supply voltage (VCC).

**Revendications**

1. Dispositif de référenciation automatique d'une cellule ( FCS, T ) ferroélectrique à mémoire, qui est constituée d'un condensateur ( FCS ) de mémoire ferroélectrique ayant une plaque de cellule et d'un transistor ( T ) de transfert et qui est prévue dans un champ de cellules de mémoire commandé par des lignes ( WL ) de mots et des par des lignes ( BL ) de bits, le condensateur ( FCS ) de mémoire ferroélectrique se trouvant entre une ligne ( CP ) de plaques de cellule et le transistor ( T ) de transfert et pour la référenciation automatique au moyen d'un évaluateur ( 1 ), la cellule de mémoire étant lue à nouveau après l'opération de lecture pour obtenir une tension de référence, les cellules ( FCS, T ) de mémoire pouvant être lues les unes après les autres, tandis que la ligne ( CP ) de plaques de cellule peut être alimentée en une deuxième ou en une première valeur de tension et en ce que les deux valeurs de tension obtenues peuvent être emmagasinées intermédiairement dans une première ou une deuxième capacité ( CK1, CK2 ; CBSA, CPSA ; CBS1, CBS2 ) avant d'être envoyées à l'évaluateur ( 20 ) pour y être comparées entre elles,
   **caractérisé en ce que**
   la ligne ( BL ) de bits pour les deux opérations de lecture est préchargée successivement à deux tensions différentes l'une de l'autre et opposées ( VCC, 0 V ) ayant une première et une deuxième valeur de tension et, de fait, ayant la première tension pour la première opération de lecture et ayant la deuxième tension pour la deuxième opération de lecture.

2. Dispositif suivant la revendication 1,
   **caractérisé en ce que**
   les plaques de cellule sont reliées entre elles à la manière de lignes parallèlement aux lignes ( BL ) de bits et **en ce que** la tension de référence peut être obtenue sur la ligne ( CP ) de plaques de cellule ( figure 11 ).

3. Dispositif suivant la revendication 1,
   **caractérisé en ce que**
   les plaques de cellule peuvent être reliées entre elles à la manière de lignes parallèlement aux lignes ( WL ) de mots et **en ce que** la tension de référence peut être obtenue sur la ligne ( BL ) de bits ( figure 15 ).

**4.** Dispositif suivant l'une des revendications 1 à 3,
**caractérisé en ce que**
après la première précharge, la ligne ( BL ) de bits bloque le transistor ( T ) de transfert.

**5.** Dispositif suivant l'une des revendications 1 à 4,
**caractérisé en ce que**
une ligne ( CP ) de plaques de cellule est utilisée conjointement par deux lignes ( BL ) de bits.

**6.** Dispositif suivant l'une des revendications 1 à 5,
**caractérisé en ce que**
les lignes ( BL ) de bits et la ligne ( CP ) de plaques de cellule sont entrecroisées entre elles au moins une fois.

**7.** Dispositif suivant l'une des revendications 1 à 6,
**caractérisé en ce que**
les deux tensions différentes l'une de l'autre sont données par 0 V et par une tension ( VCC ) d'alimentation.

## Fig. 1

## Fig. 2

11

## Fig. 3

herkömmliches
Ausleseverfahren

Ausleseverfahren bei Erfindung

## Fig. 4

# Fig. 5

| CBL Vorladen auf 3V | Auslesen des Zell-inhalts | CBL Vorladen auf 0V | Auslesen der Referenz | Span-nungs-shift an CK1 und CK2, Bewerten | Rück-schreiben in Zelle |

## Fig. 6

## Fig. 7

## Fig. 8

## Fig. 9

"0" $\Rightarrow \Delta U_{R0} > \Delta U_{L0}$

$\Delta U_{R0}$

$\Delta U_{L0}$

Schritt I:               $U_{CP} = 0V$               $U'_{BL} = VCC$
Schritt II: $U''_{BL} = 0V$     $U_{CP} = VCC$

15

# Fig. 10

Schritt I:
Schritt II: U"$_{BL}$ = 0V

U$_{CP}$ = 0V
U$_{CP}$ = VCC

U'$_{BL}$ = VCC

# Fig. 11

# Fig. 12

| | Vorladen CBL = CBSA = VCC, CP = 0V | Auslesen auf CBL und CBSA | Vorladen CBL = 0V, CP = CPSA = VCC | Auslesen auf CP und CPSA | Bewerten | Rück-schreiben |
|---|---|---|---|---|---|---|

# Fig. 13

# Fig. 14

# Fig. 16

| | | | | | |
|---|---|---|---|---|---|
| Vorladen CBL = CBS1 = VCC, CP = 0V | Auslesen auf CBL und CBS1 | Vorladen CBL = CBS2 = 0V, CP=VCC | Auslesen auf CBL und CBS2 | Bewerten | Rückschreiben über CBL und CP |

## Fig. 15

## Fig. 17

## Fig. 18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5262982 A